## Europäisches Patentamt

## European Patent Office

## Office européen des brevets

(19)

(11)  **EP 0 401 917 B1**

(12)  **EUROPÄISCHE PATENTSCHRIFT**

(45) Veröffentlichungstag und Bekanntmachung des
Hinweises auf die Patenterteilung:
**04.09.1996  Patentblatt 1996/36**

(51) Int Cl.⁶: **G01R 33/34**

(21) Anmeldenummer: **90201410.9**

(22) Anmeldetag: **05.06.1990**

(54) **Hochfrequenz-Quadraturspulenanordnung**

High-frequency quadrature coil system

Système de bobines haute-fréquence en quadrature

(84) Benannte Vertragsstaaten:
**DE FR GB**

(30) Priorität: **08.06.1989  DE 3918743**

(43) Veröffentlichungstag der Anmeldung:
**12.12.1990  Patentblatt 1990/50**

(73) Patentinhaber:
• **Philips Patentverwaltung GmbH
22335 Hamburg (DE)**
Benannte Vertragsstaaten:
**DE**
• **Philips Electronics N.V.
5621 BA Eindhoven (NL)**
Benannte Vertragsstaaten:
**FR GB**

(72) Erfinder: **Leussler, Christoph Günter
D-2000 Hamburg 20 (DE)**

(74) Vertreter: **Hartmann, Heinrich, Dipl.-Ing. et al
Philips Patentverwaltung GmbH,
Röntgenstrasse 24
D-22335 Hamburg (DE)**

(56) Entgegenhaltungen:
**EP-A- 0 342 745          EP-A- 0 349 198
EP-A- 0 352 824          EP-A- 0 361 190
FR-A- 2 562 250          US-A- 4 766 383
US-E- 32 689**

• **7th Annual Meeting and Exhibition, Soc. of
Magnetic Resonance in Medicine August 1988,
San Francisco, California Seite 111 L.Li et al.: "A
highly efficient double-tuned resonator for
phosphorus-31 imaging in ex-vivo bone"**

**Beschreibung**

Die Erfindung betrifft eine Hochfrequenzspulenanordnung nach dem Oberbegriff des Anspruchs 1. Eine solche Anordnung ist aus der EP-B 71896 bekannt. Sie kann zum Empfang von Kernresonanzsignalen und/ oder zur Erzeugung von hochfrequenten magnetischen Feldern benutzt werden. Beim Empfang kann damit gegenüber dem Empfang mit einer dieser Spulen eine Verbesserung des Signal/Rausch-Verhältnisses um bis zu 3 dB erreicht werden. Bei Verwendung dieser Spule im Sendebetrieb können damit zirkular polarisierte magnetische Hochfrequenzfelder erzeugt werden, wenn den beiden Hochfrequenzspulen Hochfrequenzströme zugeführt werden, die um 90° in der Phase gegeneinander versetzt sind, wodurch sich der Sendeleistungsbedarf auf die Hälfte reduziert. Die Hochfrequenzfelder müssen dabei nicht nur zueinander senkrecht verlaufen, sondern auch senkrecht zu dem stationären homogenen Magnetfeld, das Voraussetzung für die auf magnetischer Kernresonanz basierenden Untersuchungen ist.

Bei der bekannten Anordnung sind die Hochfrequenzspulen Sattelspulen. Diese auf den Oberflächen eines zylinderförmigen Trägerkörpers angebrachten Sattelspulen erzeugen Magnetfelder, die zu der Achse des Trägerkörpers senkrecht stehen. Berücksichtigt man, daß bei Untersuchungen eines Patienten, dessen Längsachse mit der Achse des Trägerkörpers zusammenfallen muß, dann wird deutlich, daß solche Quadraturspulen nur für Kernspinuntersuchungsgeräte geeignet sind, bei denen das von dem Kernspinuntersuchungsgerät erzeugte homogene stationäre Magnetfeld in Richtung der Achse des Trägerkörpers, d.h. in Längsrichtung des Patienten, verläuft.

Weiterhin ist aus der US-PS 4,766,383 eine Hochfrequenz-Quadratur-Spulenanordnung bekannt, die zwei Spulenpaare aufweist. Jede der vier Spulen hat eine elliptische Form, und ihr Mittelpunkt liegt auf der Längsachse der Antenne. Die kleineren Achsen beider Spulenpaare sind jeweils kolinear und senkrecht zu den kleineren Achsen der Spulen von dem jeweils anderen Spulenpaar.

Aufgabe der vorliegenden Erfindung ist es, eine Quadraturspulenanordnung der eingangs genannten Art zu schaffen, die sich für Kernspinuntersuchungsgeräte eignet, deren homogenes stationäres Magnetfeld senkrecht zur Längsachse eines darin untersuchten Patienten verläuft.

Diese Aufgabe wird erfindungsgemäß dadurch gelöst, daß jede Hochfrequenzspule mehrere Windungen umfaßt, die in zueinander parallelen Ebenen liegen, daß die Windungsebenen der einen Hochfrequenzspule senkrecht zu den Windungsebenen der anderen Hochfrequenzspule verlaufen, daß die Windungen durch kapazitive Kopplung ihrer Enden als Resonatoren ausgebildet sind und daß die Resonatoren jeder Hochfrequenzspule lediglich induktiv miteinander gekoppelt sind.

Bei der Erfindung weist also jede Hochfrequenzspule mehrere Windungen auf, die in zueinander parallelen Ebenen liegen. Das von einer solchen Hochfrequenzspule erzeugte hochfrequente Magnetfeld verläuft senkrecht zu den Windungsebenen. Diese Windungen umschließen beispielsweise den Körper des Patienten oder seinen Schädel und innerhalb eines Kernspinuntersuchungsgerätes verlaufen die hochfrequenten Magnetfelder dann senkrecht zu dem stationären homogenen Magnetfeld, wenn dieses parallel zu den Windungsebenen beider Spulen und damit senkrecht zur Längsachse des Patienten verläuft.

In der Regel weisen die einzelnen Windungen einer Hochfrequenzspule nicht die erforderliche mechanische Stabilität auf. Die Windungen müssen daher gestützt werden.

Eine erste Weiterbildung sieht zu diesem Zweck vor, daß die beiden Hochfrequenzspulen einen gemeinsamen zylinderförmigen Trägerkörper aufweisen und daß die Windungsebenen beider Spulen die Achse des Trägerkörpers unter einem von 90° verschiedenen Winkel schneiden und aufeinander senkrecht stehen.

Eine zweite Weiterbildung sieht zu diesem Zweck demgegenüber vor, daß die beiden Spulen auf je einem zylinderförmigen Trägerkörper so angeordnet sind, daß die Achsen der Körper senkrecht zu den Windungsebenen stehen, daß die Trägerkörper so angeordnet sind, daß sich ihre Achsen unter einem Winkel von 90° schneiden und daß die beiden Trägerkörper jeweils einen Teil des anderen Trägerkörpers umschließen. Diese Weiterbildung eignet sich zur Untersuchung des Schädels oder der Extremitäten eines Patienten, nicht aber für Ganzkörperuntersuchungen.

Die Erfindung wird nachstehend anhand der Zeichnung näher erläutert. Es zeigen:

Fig. 1 ein Kernspinuntersuchungsgerät mit einer Hochfrequenz-Quadraturspulenanordnung in schematischer Darstellung.

Fig. 2 eine erste Ausführungsform einer Hochfrequenzspule,

Fig. 3 eine zweite, nicht zur Erfindung gehörende Ausführungsform einer Hochfrequenzspule

Fig. 4 eine Ausführugnsform, bei der die beiden Hochfrequenzspulen auf einem gemeinsamen Trägerkörper angeordnet sind und

Fig. 5 eine Ausführungsform, bei der für jede Hochfrequenzspule ein gesonderter Trägerkörper vorgesehen ist.

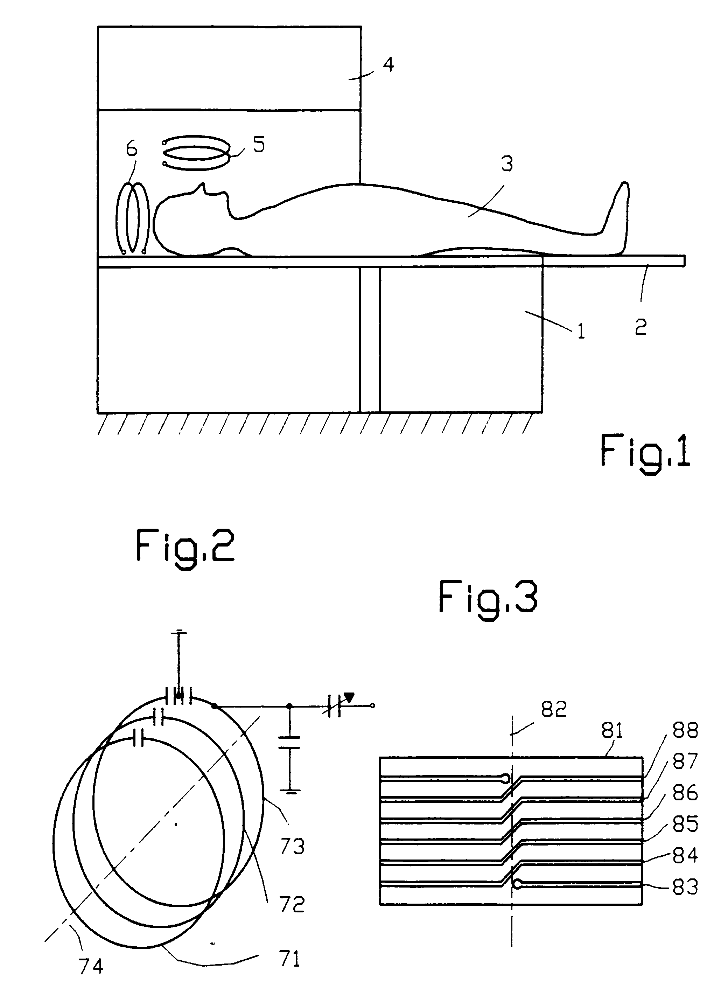

Das in Fig. 1 dargestellte Kernspinuntersuchungsgerät umfaßt unter anderem einen Patientenlagerungstisch 1, auf dessen Lagerungsplatte 2 sich ein Patient 3 in horizontaler Position befindet. Weiter gehört zu dem Kernspinuntersuchungsgerät eine Einheit 4, die den Körper des Patienten mindestens teilweise umschließt. Diese Einheit enthält unter anderem einen Magneten zur Erzeugung eines homogenen stationären Magnetfeldes in einem den Patienten umfassenden Untersuchungsbereich. Dieses Magnetfeld verläuft senkrecht zur Längsrichtung des Patienten 3. Außerdem sind zwei in Fig. 1 nur schematisch angedeutete gleichartige Hochfrequenzspulen 5 und 6 vorgesehen, die zusammen eine Quadraturspulenanordnung bilden. Diese Hochfrequenzspulen können zur Erzeugung hochfrequenter Magnetfelder und/oder zum Empfang von Kernresonanzsignalen aus dem Untersuchungsbereich dienen. Die Spulen 5 und 6 müssen dabei so ausgerichtet sein, daß die mit ihnen erzeugbaren Magnetfelder senkrecht zu dem Magnetfeld der jeweils anderen Spule und senkrecht zum homogenen stationären Magnetfeld verlaufen. Die Spulen müssen dabei auf die sogenannte Larmorfrequenz f abgestimmt sein, die sich aus der Magnetflußdichte B des homogenen stationären Magnetfeldes nach der Beziehung

$$f = cB$$

berechnet, wobei c das gyromagnetische Verhältnis ist, das für Protonen beispielsweise 42,5 MHz/T beträgt. Im Sendebetrieb werden den Spulen 5 und 6 Hochfrequenzströme mit der Larmorfrequenz zugeführt, die in der Phase um 90° gegeneinander versetzt sind.

In der Figur 2 ist eine Möglichkeit für den Aufbau der Spule angedeutet, die zusammen mit einer gleichartigen, um 90° räumlich versetzten Spule des gleichen Typs eine Quadraturspulenanordnung bilden kann.

Fig. 2 zeigt eine einzelne Hochfrequenzspule, die aus mehreren Resonatoren besteht. Jeder Resonator umfaßt dabei eine kreisförmige Leiterschleife 71, 72 bzw. 73, die in parallelen Ebenen und konzentrisch zu einer gemeinsamen Achse 74 angeordnet sind. Diese Leiterschleifen werden durch wenigstens einen Kondensator auf jeweils dieselbe Resonanzfrequenz abgestimmt. Eine Hochfrequenzspule dieser Art ist aus der deutschen Patentanmeldung P 38 16 831.6 bekannt.

Eine solche Spule hat so viele Schwingungsmoden, wie es Resonatoren gibt. Bei einem Schwingugnsmodus fließen die Ströme in sämtlichen Resonatoren mit dem gleichen Umlaufsinn. Dieser Schwingungsmodus, der für die Kernresonanzuntersuchungen ausqenutzt wird, ist mit der niedrigsten Resonanzfrequenz verknüpft, die unterhalb der Frequenz liegt, auf die die einzelnen Resonatoren abgestimmt sind. Die einzelnen Resonatoren sind dabei nur induktiv miteinander gekoppelt. Diese induktive Kopplung ermöglicht es, zum Erzeugen magnetischer Hochfrequenzfelder nur eine Windung - bei Fig. 2 die Windung 73 - an einen Hochfrequenzsender bzw. einen Hochfrequenzempfänger anzuschließen. Die magnetische Kopplung zwischen den Windungen bewirkt, daß im Sendebetrieb auch in der Ebene des nicht angeschlossenen Resonators 71 ein Hochfrequenzfeld erzeugt wird bzw. daß in dieser Ebene erzeugte Kernresonanzsignale empfangen werden können, wenngleich das hochfrequente Magnetfeld in dieser Ebene etwas schwächer ist als in der Ebene des Resonators 73 bzw. die Empfindlichkeit der Ebene des Resonators 71 geringer ist als für solche aus der Ebene des Resonators 73. Welcher der Resonatoren im Einzelfall angeschlossen wird, hängt im einzelnen von der Untersuchungssituation ab.

Bei vorgegebenen geometrischen Abmessungen einer Leiterschleife 71 .. 73 hängt die Größe der an ihre Enden anzuschließenden Kapazität nur von der Betriebsfrequenz ab. Die Kapazität muß daher umso größer sein, je niedriger die Betriebsfrequenz ist. Kondensatoren mit größeren Kapazitäten haben aber eine geringere Güte als solche mit kleinerer Kapazität, so daß auch die Güte des durch die Leiterschleife und wenigstens einen Kondensator gebildeten Resonators mit abnehmender Frequenz abnimmt.

In der Praxis müssen aus Gründen der mechanischen Stabilität die Windungen 71..73 auf der Oberfläche eines hohlzylinderförmigen Trägerkörpers angeordnet sein. Dieser Trägerkörper ist in Fig. 2 nicht näher dargestellt.

In Fig. 3 ist ein anderer, nicht zur Erfindung gehörender Typ einer Spule dargestellt, die zusammen mit einer weiteren Spule des gleichen Typs eine Quadraturspule bilden kann. Es handelt sich dabei um eine sogenannte Solenoidspule mit einer einzigen Wicklung aus mehreren Windungen. Grundsätzlich könnte eine solche Spule durch einen wendelartig mit gleicher Steigung auf einen Trägerkörper gewickelten Leiter gebildet werden.

In Fig. 3 sind demgegenüber auf den Trägerkörper 81 mit der Symmetrieachse 82 in zueinander parallelen Ebenen mehrere Windungen 83..88 gewickelt. Alle Windungen sind über einen kleinen Teil des Umfangs des Wicklungskörpers unterbrochen. Von dem dadurch gebildeten freien Ende ist jeweils das linke Ende einer jeden Windung mit dem rechten Ende der darüberliegenden Windung verbunden. Auf diese Weise bleiben nur das rechte Ende der Windung 83 und das linke Ende der Windung 84 frei, die die Anschlüsse der Solenoidspule bilden und zwischen die zu Abstimmungszwecken ein Kondensator geschaltet wird. Eine solche Spule weist eine hohe Betriebsgüte auf, solange die Gesamtlänge der (galvanisch in Serie geschalteten) Windungen kleiner ist als ein Viertel der Wellenlänge der jeweiligen Betriebsfrequenz. Die Betriebsgüte dieses Spulentyps nimmt also zu höheren Frequenzen hin ab.

Es gibt daher eine Grenzfrequenz, bei der die Betriebsgüten der in Fig. 2 und Fig. 3 dargestellten Spulen gleich sind. Unterhalb dieser Frequenz hat die in Fig. 3 dargestellte Spule und oberhalb dieser Frequenz die in Fig. 2 dargestellte Spule eine höhere Betriebsgüte. Die Frequenz hängt vom Durchmesser der Windungen und ihrer Windungszahl ab. Bei einer Kopfspule mit einem Windungsdurchmesser von 30 cm und insgesamt 11 Windungen liegt diese Frequenz bei ca. 2,5 MHz. Dies ist die Larmorfrequenz, die sich in einem Kernresonanz-Untersuchungsgerät mit einer Magnetflußdichte von rund 0,06 Tesla einstellt.

Die hohlzylinderförmigen Trägerkörper, die die Spulen gemäß Fig. 2 bzw. Fig. 3 tragen, können einen kreisförmigen oder einen elliptischen Querschnitt haben. Ihr Querschnitt kann jedoch auch rechteckig oder vieleckig sein. Abmessungen und Formen des Querschnitts sollten der Anatomie eines typischen Patienten so angepaßt sein, daß die Windungen möglichst dicht beim Patienten liegen. Dadurch wird (im Empfangsfall) eine gute Empfindlichkeit erreicht bzw. (im Sendefall) eine geringe Sendeleistung benötigt.

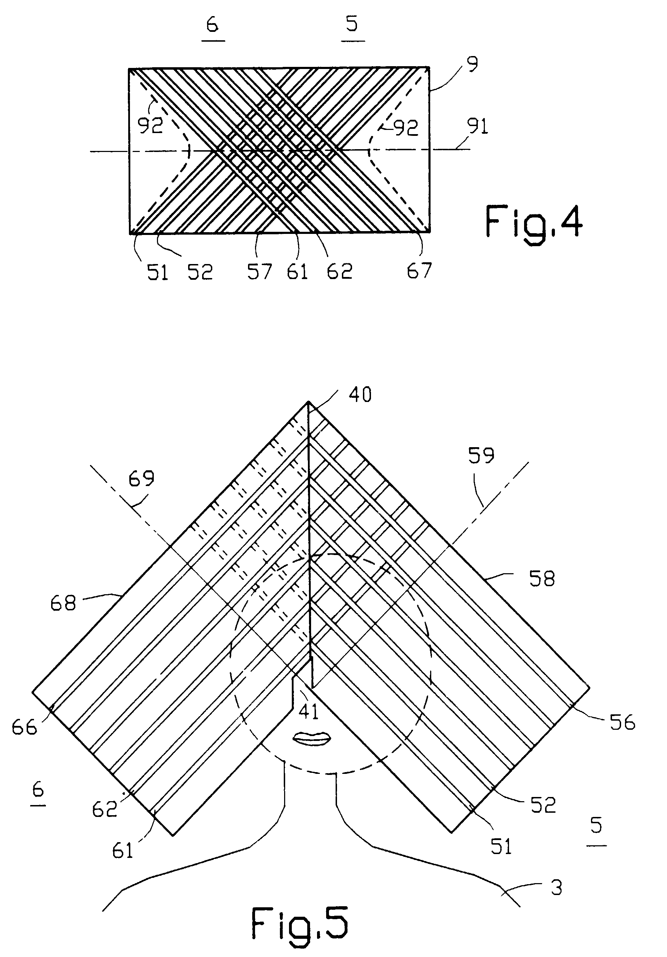

Fig. 4 zeigt ein erstes Ausführungsbeispiel einer Quadraturspule nach der Erfindung. Die Quadraturspule besitzt einen hohlzylinderförmigen Trägerkörper 9, dessen Zylinderachse mit 91 bezeichnet ist. In diesen Trägerkörper, der wie allgemein üblich aus einem elektrisch isolierenden, magnetisch neutralen Material besteht, wird bei einer Untersuchung der Körper des Patienten oder sein Schädel eingeführt. Die Längsachse des Patienten verläuft dann parallel zur Zylinderachse 91. Auf den Trägerkörper 9 sind die beiden Hochfrequenzspulen 5 und 6 aufgebracht, die zusammen die Quadraturspule bilden. Die Windungen 51..57 der Hochfrequenzspule 5 befinden sich in parallelen Ebenen, die die Zylinderachse 91 unter einem Winkel von 45° schneiden. Die Ebenen, in denen sich die Windungen 61..67 der Hochfrequenzspule 6 befinden, sind ebenfalls zueinander parallel und schneiden die Achse 91 ebenfalls unter einem Winkel von 45°, jedoch verlaufen diese Ebenen senkrecht zu denen der Windungen 51..57. Die Windungen 51..57 einerseits und 61..67 andererseits kreuzen sich daher.

Um zu verhindern, daß die Windungen der einen Spule galvanischen Kontakt mit den Windungen der anderen Spule erhalten, kann im Kreuzungsbereich eine isolierende Folie vorgesehen sein. Die Leiter, die die einzelnen Windungen bilden, können einen flachen (bandförmigen) Querschnitt haben oder einen rohrförmigen Querschnitt. Bei einem rohrförmigen Querschnitt können diese Leiter an den Stellen, an denen sie die Leiter der anderen Hochfrequenzspule kreuzen, zusammengedrückt sein, und an diesen Stellen können Isolierscheiben zwischen die sich kreuzenden Leiter gelegt sein. Dadurch läßt sich erreichen, daß auch im Kreuzungsbereich der Windungen deren äußerer Umfang kaum zunimmt.

Das von der Spule 5 erzeugte magnetische Hochfrequenzfeld verläuft senkrecht zu den Windungsebenen der Windungen dieser Spule und parallel zu den Windungsebenen der Spule 6. Ebenso verläuft das von der Spule 6 erzeugte Hochfrequenzfeld senkrecht zu den Ebenen der Windungen dieser Spule und parallel zu den Windungsebenen der Spule 5. Bei Verwendung dieser Spule in einem Gerät nach Fig. 1 muß das homogene stationäre Magnetfeld parallel zu den Windungsebenen beider Spulen verlaufen, d.h. senkrecht zu der Zeichenebene der Fig. 4 bzw. der Fig. 1.

Die Quadraturspule gemäß Fig. 4 kann für Ganzkörperuntersuchungen eingesetzt werden, wenn der Innendurchmesser des Trägerkörpers 9 genügend groß ist, um der Körper des Patienten 3 (Fig. 1) aufzunehmen. Wenn das homogene stationäre Magnetfeld, das von der Einheit 4 erzeugt wird (Fig. 1), nicht senkrecht zur Zeichenebene der Fig. 1 verläuft sondern vertikal, kann diese Quadraturspule ebenfalls zu Untersuchungen des Körpers benutzt werden - wenn sie aus der in Fig. 4 dargestellten Stellung um 90° um die Achse 91 gedreht wird.

Die Quadraturspule gemäß Fig. 4 kann auch zu Schädeluntersuchungen benutzt werden, wobei ihr Innendurchmesser kleiner sein kann als für Ganzkörperuntersuchungen erforderlich. Für diese Zwecke kann, wie durch die gestrichelten Linien 92 angedeutet, die Öffnung des Trägerkörpers 9 in den von Windungen freien Bereich hinein erweitert werden. In diesem Öffnungsbereich befinden sich bei einer Schädeluntersuchung die Schultern des Patienten. Der Kopf ragt dann in den Bereich hinein, beiderseits dessen sich die Windungen der Spule kreuzen. Nur in diesem Bereich und dessen näherer Umgebung ergibt sich im Sendebetrieb ein zirkular polarisiertes Hochfrequenzfeld bzw. im Empfangsbetrieb eine größere Empfindlichkeit.

Geht man davon aus, daß die Schultern des Patienten 3 bei einer Schädeluntersuchung auf der Tischplatte 2 liegen müssen, dann setzt dies voraus, daß die Quadraturspule in der in Fig. 4 dargestellten Weise in einem Kernspinuntersuchungsgerät plaziert wird und daß das darin erzeugte homogene stationäre Magnetfeld horizontal und senkrecht zu den Zeichenebenen der Fig. 1 und Fig. 4 verläuft. Verläuft das homogene stationäre Magnetfeld stattdessen vertikal, dann ist es nicht möglich, die Spule 9 um 90° (um die Achse 91) zu drehen, weil der Schädel des Patienten dann nicht tief genug in den Trägerkörper 91 eingeführt werden kann.

Eine Quadraturspulenanordnung, die sich für diesen Fall eignet, ist in Fig. 5 dargestellt. Jede der beiden Spulen 5 bzw. 6 besitzt dabei einen eigenen hohlzylinderförmigen Trägerkörper 58 bzw. 68 mit ringförmigem Querschnitt. Die Zylinderachsen 59 bzw. 69 dieser Körper schneiden sich rechtwinklig. Zur Erzielung eines möglichst großen Einführungsbereiches für den Schädel des Patienten wäre es an sich erwünscht, die Spulen 5 und 6 so anzuordnen, daß die einander zugewandten Ränder der Trägerkörper 58,68 allenfalls einander berühren. Da der vom Magnetfeld erfüllte Raum einer derartigen Spule sich im wesentlichen auf das Innere eines jeden Trägerkörpers und seine nähere Umgebung beschränkt, gäbe es nur einen sehr kleinen Bereich, in dem sich die Felder überlagern und die gewünschten Eigenschaften einer Quadraturspule resultieren. Würde man stattdessen die Spulen so zusammenfügen, daß die Achse 59 bzw. 69 der einen Spule mit der Mittelebene der jeweils anderen Spule zusammenfiele, dann ergäbe sich zwar ein großes Volumen mit zirkular polarisiertem magnetischem Feld bzw. mit günstigen Empfangseigenschaften, jedoch wären die Öffnungen eines olchen Gebildes nicht groß genug für den Schädel eines Patienten. Die in Fig. 5 dargestellte Anordnung stellt daher einen Kompromiß zwischen den einander widersprechenden Forderungen dar.

In Fig. 5 sind die beiden Trägerkörper 58, 68 so angeordnet, daß die Zylinderachse 59 bzw. 69 in der Stirnfläche des anderen Trägerkörpers liegt. Bei gleichem Durchmesser der Trägerkörper ist es dann unvermeidlich, daß die Mantelflächen dieser Körper einander durchdringen. Bei realen Körpern bedeutet das, daß einer der beiden Körper im Durchdringungsbereich, der in Fig. 5 durch die Gerade 40 angedeutet ist, unterbrochen sein muß. Im Ausführungsbeispiel ist dies der Trägerkörper 58. Die Windungen 61,..66 der Spule 6 sind auf den anderen Trägerkörper 68 aufgebracht - ohne Unterbrechung im Durchdringungsbereich 40. Dieser Trägerkörper weist lediglich an den beiden einander gegenüberliegenden Stellen, in denen die Schnittgerade der einander zugewandten Stirnflächen der Trägerkörper 58, 68 den Träger 68 schneidet, eine Öffnung 41 für den Trägerkörper 58 auf. Hingegen ist der Trägerkörper 58 im Durchdringungsbereich unterbrochen - und damit auch die auf ihn angebrachten Windungen 51..56 der Spule 5. Um den elektrischen Kontakt dieser Windungen vor (ausgezogene Linien) und nach der Unterbrechung (gestrichelte Linien) herzustellen, muß im Bereich der Unterbrechung eine Kontaktierung durch den Trägerkörper 68 hindurch erfolgen.

Fig. 5 zeigt die Lage der Quadraturspule 5, 6 in bezug auf den Schädel des Patienten 3. Die von dieser Spule erzeugten Hochfrequenzfelder wirken also unter einem Winkel von jeweils 45° in bezug auf die Längsachse des Patienten auf diesen ein. Bei Kernresonanzuntersuchungen muß das homogene stationäre Magnetfeld parallel zu den Windungsebenen der Spulen 5 und 6 verlaufen, d.h. es muß senkrecht zur Zeichnungsebene der Fig. 5 verlaufen bzw. in Fig. 1 vertikal. Bei einem Innendurchmesser der Trägerkörper 58,68 von 30 cm ergibt sich für die Einführung des Schädels des Patienten eine freie Öffnung von ca. 22 cm Breite und 30 cm Höhe.

Eine Quadraturspule zeigt nur dann das erwünschte Verhalten, wenn die beiden Hochfrequenzspulen, aus denen sie gebildet wird, vollständig voneinander entkoppelt sind. Das bedeutet, daß das von der einen Spule erzeugte Hochfrequenzfeld in der andren Spule keinerlei Spannung induzieren darf. In der Praxis lassen sich kleine Unsymmetrien, die zu einer solchen Verkopplung führen können, nicht ganz vermeiden. Um in diesem Fall die erforderliche Entkopplung sicherzustellen, können die Spulen 5 und 6 über eine geeignete Entkopplungsschaltung miteinander verbunden sein, die in der jeweils anderen Spule einen Strom hervorruft, der den Strom gerade kompensiert, der durch die magnetische Kopplung zwischen den beiden Spulen hervorgerufen wird. Im einfachsten Fall kann dazu ein Kondensator dienen, wie im einzelnen in der deutschen Patentanmeldung P 38 20 168.2 beschrieben.

## Patentansprüche

1.  Hochfrequenz-Quadraturspulenanordnung für ein Kernspinresonanzuntersuchungsgerät mit zwei an einen Hochfrequenzempfänger und/oder einen Hochfrequenzsender anschließbaren, gleichartigen Hochfrequenzspulen (5,6),
    dadurch gekennzeichnet, daß jede Hochfrequenzspule (5,6) mehrere Windungen (51..56, 61..66) umfaßt, die in zueinander parallelen Ebenen liegen, daß die Windungsebenen der einen Hochfrequenzspule (5) senkrecht zu den Windungsebenen der anderen Hochfrequenzspule (6) verlaufen, daß die Windungen durch kapazitive Kopplung ihrer Enden als Resonatoren (71..73) ausgebildet sind und daß die Resonatoren jeder Hochfrequenzspule lediglich induktiv miteinander gekoppelt sind.

2.  Hochfrequenz-Quadraturspulenanordnung nach Anspruch 1,
    gekennzeichnet durch Mittel zum Anschließen jeweils eines der Resonatoren der beiden Hochfrequenzspulen an einen Hochfrequenzsender bzw. an einen Hochfrequenzempfänger.

3.  Hochfrequenzspulenanordnung nach Anspruch 2,
    dadurch gekennzeichnet, daß die beiden Hochfrequenzspulen einen gemeinsamen zylinderförmigen Trägerkörper (9) aufweisen und daß die Windungsebenen beider Spulen die Achse des Trägerkörpers unter einem von 90° verschiedenen Winkel schneiden und aufeinander senkrecht stehen.

4.  Hochfrequenzspulenanordnung nach Anspruch 1 oder Anspruch 2,
    dadurch gekennzeichnet, daß die beiden Spulen auf je einem zylinderförmigen Trägerkörper (58,68) so angeordnet sind, daß die Achsen der Körper senkrecht zu den Windungsebenen stehen, daß die Trägerkörper so angeordnet sind, daß sich ihre Achsen (59,69) unter einem Winkel von 90° schneiden und daß die beiden Trägerkörper jeweils einen Teil des anderen Trägerkörpers umschließen.

## Claims

1.  An rf quadrature coil system for a magnetic resonance examination apparatus, comprising two similar rf coils (5, 6) which can be connected to an rf receiver and/or an rf transmitter, characterized in that each rf coil (5, 6) comprises several turns (51 ... 56, 61 .... 66) which are situated in mutually parallel planes, that the planes of the turns of one rf coil (5) extend perpendicularly to the planes of the turns of the other rf coil (6), that the turns are formed as resonators (71 ... 73) by capacitive coupling of their ends, and that the resonators of each rf coil are being only inductively coupled to one another.

2. An rf quadrature coil system as claimed in Claim 1, characterized in that it comprises means for connecting each time one of the resonators of the two rf coils to an rf transmitter or an rf receiver.

3. An rf coil system as claimed in Claim 2, characterized in that the two rf coils have a common cylindrical supporting means (9) and that, the planes of the turns of the two coils intersect the axis of the supporting means at an angle other than 90° and extend perpendicularly to one another.

4. An rf coil system as claimed in Claim 1 or Claim 2, characterized in that each of the two coils is arranged on a respective cylindrical supporting means (58, 68) so that the axes of the means extend perpendicularly to the planes of the turns, that the supporting means are arranged so that their axes (59, 69) intersect at an angle of 90°, and that the two supporting means enclose each time a part of the respective other supporting means.

**Revendications**

1. Système de bobines haute fréquence en quadrature pour un appareil d'examen à résonance magnétique nucléaire comportant deux bobines haute fréquence (5, 6) de même type pouvant être connectées à un récepteur haute fréquence ou à un émetteur haute fréquence, caractérisé en ce que chaque bobine haute fréquence (5, 6) comprend plusieurs spires (51 ... 56, 61 ... 66), qui se trouvent dans des plans mutuels parallèles, en ce que les plans des spires de la première bobine haute fréquence (5) s'étendent perpendiculairement aux plans des spires de l'autre bobine haute fréquence (6), les spires sont conçues comme des résonateurs (71 ... 73) par couplage capacitif de leurs extrémités et que les résonateurs de chaque bobine haute fréquence sont couplés l'un à l'autre uniquement par induction.

2. Système de bobines haute fréquence en quadrature selon la revendication 1, caractérisé par des moyens pour raccorder respectivement un des résonateurs des deux bobines haute fréquence à un émetteur haute fréquence et à un récepteur haute fréquence.

3. Système de bobines haute fréquence selon la revendication 2, caractérisé en ce que les deux bobines haute fréquence présentent un corps de support (9) commun de forme cylindrique et que les plans des spires des deux bobines coupent l'axe du corps de support sous un angle différent de 90° et sont perpendiculaires l'un à l'autre.

4. Système de bobines haute fréquence selon la revendication 1 ou 2, caractérisé en ce que les deux bobines sont agencées chacune sur un corps de support de forme cylindrique (58, 68), que les axes des corps sont perpendiculaires aux plans des spires, que les corps de support sont agencés de telle manière que leurs axes (59, 69) se coupent sous un angle de 90° et que les deux corps de support entourent chacun respectivement une partie de l'autre corps de support.

Fig.1

Fig.2

Fig.3

Fig.4

Fig.5